(19) Europäisches Patentamt / European Patent Office / Office européen des brevets

(11) **EP 3 955 587 B1**

(12) **EUROPEAN PATENT SPECIFICATION**

(45) Date of publication and mention
of the grant of the patent:
**04.06.2025 Bulletin 2025/23**

(21) Application number: **20786848.0**

(22) Date of filing: **10.04.2020**

(51) International Patent Classification (IPC):
*H04Q 9/00* (2006.01)    *H04W 16/20* (2009.01)
*H04B 17/309* (2015.01)    *H04B 17/391* (2015.01)
*G01R 29/08* (2006.01)    *G06Q 50/16* (2024.01)

(52) Cooperative Patent Classification (CPC):
**H04B 17/309; G01R 29/08; G06N 20/00;
H04B 17/3912; H04W 16/20;** H04B 17/27

(86) International application number:
**PCT/JP2020/016192**

(87) International publication number:
**WO 2020/209380 (15.10.2020 Gazette 2020/42)**

(54) **MACHINE LEARNING DEVICE**

MASCHINENLERNVORRICHTUNG

DISPOSITIF D'APPRENTISSAGE AUTOMATIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **12.04.2019   JP 2019076604
12.02.2020   JP 2020021199**

(43) Date of publication of application:
**16.02.2022   Bulletin 2022/07**

(73) Proprietor: **DAIKIN INDUSTRIES, LTD.
Osaka-Shi, Osaka 530-0001 (JP)**

(72) Inventors:
• **CHEN, Chuanhsin
Osaka-shi, Osaka 530-8323 (JP)**
• **NISHIMURA, Tadafumi
Osaka-shi, Osaka 530-8323 (JP)**
• **YAMAGUCHI, Hirozumi
Suita-shi, Osaka 565-0871 (JP)**
• **HIGASHINO, Teruo
Suita-shi, Osaka 565-0871 (JP)**

(74) Representative: **Global IP Europe
Patentanwaltskanzlei
Pfarrstraße 14
80538 München (DE)**

(56) References cited:
WO-A1-2012/104983    CN-A- 106 707 035
JP-A- 2019 036 901    JP-A- 2019 140 585
US-A1- 2017 117 841

• XP055503115

**Description**

**TECHNICAL FIELD**

The present disclosure relates to a machine learning apparatus that learns a radio wave propagation state between a radio device and another radio device.

**BACKGROUND ART**

There is conventionally a system in which devices for performing heating, ventilation, air conditioning, and so on (hereinafter referred to as HVAC devices) are connected to a network and are remotely managed. In this system, a network address and information on the physical arrangement of each HVAC device in a building need to be stored in association with each other. This association work is generally performed manually in the building, and a large amount of time and cost is required for the work.

US 2017/117841 A1 and CN 106 707 035 A each disclose a machine learning apparatus comprising: an acquisition unit configured to acquire first information as information for obtaining one or more state variables.

To address the above-mentioned problem, an effort has been made in recent years for providing each HVAC device with a radio-wave transmitter/receiver (radio device), obtaining information on radio wave strengths from such radio-wave transmitters/receivers, and estimating the arrangement of the respective HVAC devices on the basis of the information. A method for simulation of a radio wave propagation state is presented in, for example, PTL 1 (Japanese Unexamined Patent Application Publication No. 2016-208265).

**SUMMARY OF THE INVENTION**

<Technical Problem>

It is possible to perform a simulation of a radio wave propagation state by using an existing method. However, there is a demand for a method that is different from and simpler or more accurate than the existing method.

<Solution to Problem>

A machine learning apparatus according to a first aspect is a machine learning apparatus for learning a radio wave propagation state between a radio device and another radio device. The machine learning apparatus includes an acquisition unit and a learning unit. The acquisition unit acquires first information as information for obtaining state variable. The first information is information related to something between the radio device and the other radio device. Examples of the first information include information related to a distance between the radio device and the other radio device, and information related to an object located between the radio device and the other radio device. The learning unit learns the state variable and the radio wave propagation state between the radio device and the other radio device in association with each other.

Here, since the acquisition unit acquires first information related to something between the radio device and the other radio device, necessary state variable can be obtained from the first information. Since the learning unit learns the state variable and the radio wave propagation state in association with each other, this machine learning apparatus can obtain a radio wave propagation state between a radio device and another radio device.

The radio wave propagation state between the radio device and the other radio device can be represented by any of the amount of radio wave attenuation between the radio device and the other radio device, a minimum transmission radio wave strength that can be received by the other radio device, the received radio wave strength of the other radio device relative to the transmission from the radio device at a predetermined transmission radio wave strength, and so on.

A machine learning apparatus according to a second aspect is the machine learning apparatus according to the first aspect, in which the first information includes information on a distance between the radio device and the other radio device. The distance between the radio device and the other radio device is at least one of the state variables.

Here, since the distance between two radio devices is adopted as a state variable, a more accurate radio wave propagation state can be obtained.

A machine learning apparatus according to a third aspect is the machine learning apparatus according to the first aspect or the second aspect, in which the first information includes object information related to a predetermined object located between the radio device and the other radio device.

Here, a state variable can be obtained from information on an object located between both radio devices that affect the radio wave propagation state. Accordingly, it is possible to obtain a more accurate radio wave propagation state.

A machine learning apparatus according to a fourth aspect is the machine learning apparatus according to the third aspect, in which the object information includes information on the number of predetermined objects.

Here, a state variable is obtained from information on the number of predetermined objects, which is relatively simple information. Accordingly, it is possible to more simply obtain a radio wave propagation state.

A machine learning apparatus according to a fifth aspect is the machine learning apparatus according to the third aspect or the fourth aspect, in which the predetermined object is an air conditioner and/or a beam arranged in a space above a ceiling.

Here, the learning unit can obtain a relatively accurate radio wave propagation state in a narrow space above the ceiling, where it is difficult for an existing radio wave propagation simulation device to obtain an accurate result.

A machine learning apparatus according to a sixth aspect is the machine learning apparatus according to any of the third aspect to the fifth aspect, in which the object information includes information related to a size of the predetermined object.

Here, information related to the size of the predetermined object located between the radio device and the other radio device is acquired as the first information. Accordingly, it is possible to obtain a more accurate radio wave propagation state.

A machine learning apparatus according to a seventh aspect is the machine learning apparatus according to any of the third aspect to the sixth aspect, in which the object information includes information related to a position of the predetermined object.

Here, information related to the position of the predetermined object located between the radio device and the other radio device is acquired as the first information. Accordingly, it is possible to obtain a more accurate radio wave propagation state.

A machine learning apparatus according to an eighth aspect is the machine learning apparatus according to any of the third aspect to the seventh aspect, in which the object information includes information related to an orientation of the predetermined object.

Here, information related to the orientation of the predetermined object located between the radio device and the other radio device is acquired as the first information. Accordingly, it is possible to obtain a more accurate radio wave propagation state.

A machine learning apparatus according to a ninth aspect is the machine learning apparatus according to the first aspect or the second aspect, in which the learning unit learns the state variable and the radio wave propagation state in association with each other, based on a learning data set. The learning data set includes a result of measuring the radio wave propagation state, and the state variable at a time of measurement of the radio wave propagation state.

Here, the radio wave propagation state is measured, and the learning unit performs learning using a learning data set including the state variable at this time and the result of the measurement. Accordingly, it is possible to obtain a more accurate radio wave propagation state.

A machine learning apparatus according to a tenth aspect is the machine learning apparatus according to any of the third aspect to the eighth aspect, in which the learning unit learns the state variable and the radio wave propagation state in association with each other, based on a learning data set. The learning data set includes a result of measuring the radio wave propagation state, and the state variable obtained from the object information at a time of measurement of the radio wave propagation state.

Here, the radio wave propagation state is measured, and the learning unit performs learning using a learning data set including the state variable at this time and the result of the measurement. Accordingly, it is possible to obtain a more accurate radio wave propagation state.

A machine learning apparatus according to an eleventh aspect is the machine learning apparatus according to the first aspect, the second aspect, or the ninth aspect, in which the learning unit learns the state variable and the radio wave propagation state in association with each other by adjusting a coefficient of a linear model in Equation 1 as follows:

$$\hat{y}(w, x) = \sum_{i=1}^{p} w_i\, x^i$$

$$\text{Equation 1}$$

where

$\hat{y}(w, x)$ denotes an estimation result of the radio wave propagation state,
w denotes a coefficient, and
x denotes a distance between the radio device and the other radio device.

A machine learning apparatus according to a twelfth aspect is the machine learning apparatus according to any of the third aspect to the eighth aspect or the tenth aspect, in which the learning unit learns the state variable and the radio wave propagation state in association with each other by adjusting a coefficient of a linear model in Equation 2 as follows:

$$\hat{y}(w, x, x') = \sum_{i=1}^{p} \sum_{j=1}^{p} w_{ij}\, x^i x'^j$$

Equation 2

where

$\hat{y}(w, x, x')$ denotes an estimation result of the radio wave propagation state,
w denotes a coefficient,
x denotes a distance between the radio device and the other radio device, and
x' denotes the number of predetermined objects located between the radio device and the other radio device.

A machine learning apparatus according to a thirteenth aspect is the machine learning apparatus according to any of the first aspect to the twelfth aspect, further including an output unit and an update unit. The output unit outputs an estimation result of the radio wave propagation state. The update unit updates a learning state of the learning unit by evaluating a difference between the estimation result of the radio wave propagation state and a result of measuring the radio wave propagation state.

Here, the learning state of the learning unit is improved, and a more accurate radio wave propagation state can be obtained.

A machine learning apparatus according to a fourteenth aspect is the machine learning apparatus according to the eleventh aspect, further including an output unit and an update unit. The output unit outputs an estimation result of the radio wave propagation state. The update unit updates a learning state of the learning unit by updating the coefficient w in Equation 1 above so as to decrease an evaluation function 1 given as follows:

$$\|\hat{y}(w, x) - y\|^2$$

where

$\hat{y}(w, x)$ denotes the estimation result of the radio wave propagation state, and
y denotes a result of measuring the radio wave propagation state.

Here, the learning state of the learning unit is improved, and a more accurate radio wave propagation state can be obtained.

A machine learning apparatus according to a fifteenth aspect is the machine learning apparatus according to the twelfth aspect, further including an output unit and an update unit. The output unit outputs an estimation result of the radio wave propagation state. The update unit updates a learning state of the learning unit by updating the coefficient w in Equation 2 above so as to decrease an evaluation function 2 given as follows:

$$\|\hat{y}(w, x, x') - y\|^2 + \alpha\|w\|^2$$

where

$\hat{y}(w, x, x')$ denotes the estimation result of the radio wave propagation state,
y denotes a result of measuring the radio wave propagation state, and
$\alpha$ denotes a regularization parameter.

Here, the learning state of the learning unit is improved, and a more accurate radio wave propagation state can be obtained.

## BRIEF DESCRIPTION OF THE DRAWINGS

Fig. 1 is a simplified longitudinal sectional view illustrating a building in which a plurality of BLE modules between which a machine learning apparatus learns a radio wave propagation state are arranged, and beams and air conditioners present in a space above the ceiling of a room in the building.

Fig. 2 is a plan view of a first floor portion of the building, including the beams and air conditioners present in the space above the ceiling.

Fig. 3 is a configuration diagram of an HVAC management system including a machine learning apparatus.

## DESCRIPTION OF EMBODIMENTS

(1) Overview of HVAC Management System

(1-1) Background for Requiring HVAC Management System

With an increasing demand for energy saving in buildings (such as office buildings or commercial facilities) and the rapid development of intelligent control technology, intelligent systems for air conditioning and ventilation are being installed in the buildings. Such systems can provide feedback control according to demand, such as monitoring temperature, humidity, $CO_2$ concentration, room occupancy, and so on to adjust the set temperature of an air conditioner on the basis of the number of people in a room.

To implement such feedback control in a specific region, it is necessary to connect HVAC devices that perform ventilation and air conditioning or sensors to a network and map the network addresses of the HVAC devices or the like to the physical locations of the HVAC devices or the like. The mapping work also called address setting has hitherto been carried out manually. The work performed on-site by workers includes work performed using a control device to activate HVAC devices one at a time, and work for writing the addresses of the HVAC devices and the like displayed on a display of the control device to a layout map.

Such work requires time and involves human error correction work. In addition, the labor cost for the work performed on-site by workers is large. For example, in the case of a large-scale building having a 50000-square-meter floor area, it takes three months for address setting even when two workers work.

(1-2) Basic Concept for Reducing Mapping Work of HVAC Management System

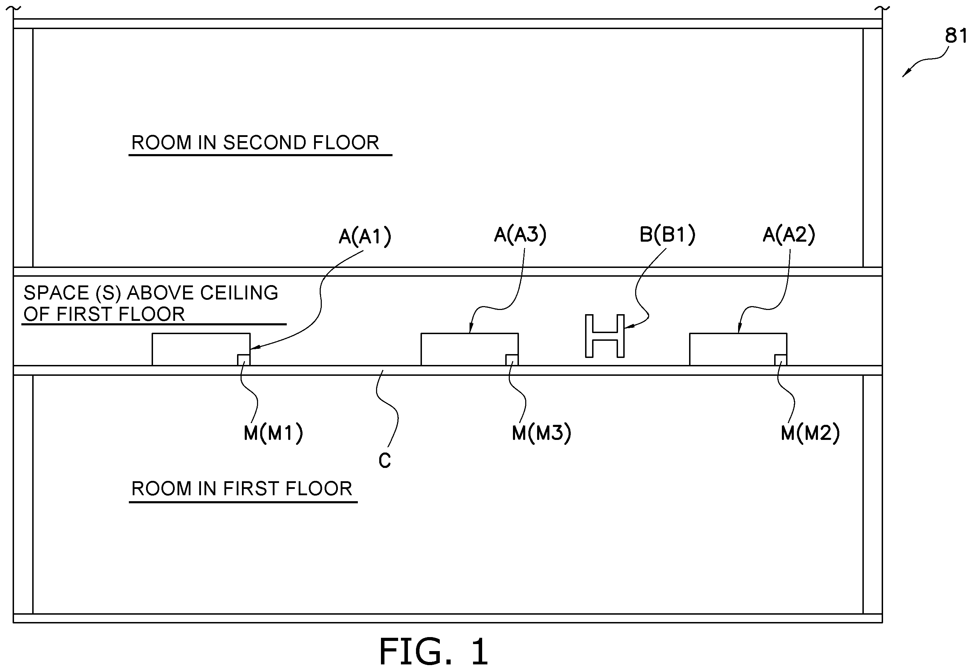

To reduce the burden of this mapping (address setting) work, this embodiment describes an HVAC management system for performing automatic mapping. In this HVAC management system, as illustrated in Fig. 1, air conditioners A, which are HVAC devices, are equipped with BLE (Bluetooth Low Energy) modules M, and the RSSIs (received signal strength indicators) of the BLE modules M are utilized. Here, the installation positions of the BLE modules M with which the air conditioners A are equipped are estimated to estimate a radio wave propagation state between the BLE modules M. The respective radio wave propagation states between the BLE modules M are estimated, thereby making it possible to facilitate mapping from these estimated values.

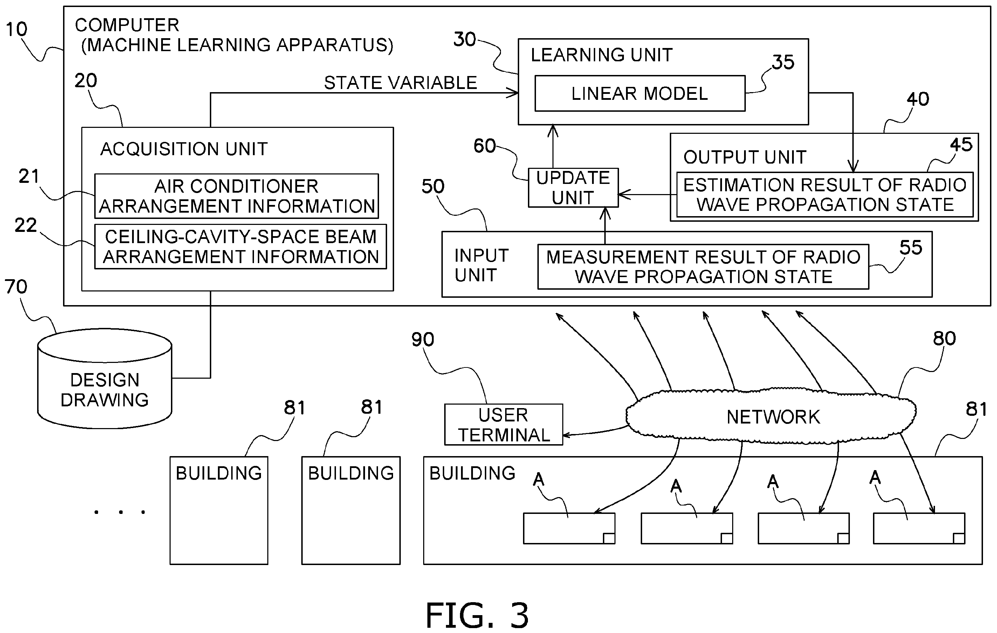

Specifically, the air conditioners A are equipped with the respective BLE modules M, and the BLE modules M perform packet communication to measure the actual received signal strength of a packet transmitted from the BLE module M on the transmission side to the BLE module M on the reception side. On the other hand, from a layout drawing of the air conditioners A, which is extracted from a design drawing (see Fig. 3) provided by a designer or the like of the building, the physical arrangement of the air conditioners A, the distance between the air conditioners A, the arrangement of obstacles that can affect the propagation of radio waves (signals), and so on are automatically read. The radio wave propagation state between a BLE module M and another BLE module M, such as the amount of radio wave attenuation between both modules M and the ratio of the received signal strength in the BLE module M on the reception side to the transmitted signal strength of the BLE module M on the transmission side, can be estimated using a linear model 35 of a learning unit 30 (see Fig. 3). The information on the arrangement of the air conditioners A or the obstacles, which is read from the layout drawing of the air conditioners A, and the linear model 35 of the learning unit 30, which is trained by enormous learning data sets previously sampled for various buildings, can be used to accurately estimate the radio wave propagation state between a BLE module M and another BLE module M.

As a result, finally, it becomes possible to automatically map network addresses to the air conditioners A installed in a space above the ceiling of the building. This can reduce the time and labor cost for the initial setting work of the intelligent system for air conditioning and ventilation (HVAC management system) in the building.

(2) Configuration of HVAC Management System

The HVAC management system is a system for managing HVAC devices that perform heating, ventilation, air conditioning, and so on. Here, the HVAC management system will be described with reference to Fig. 1 to Fig. 3 by taking, as an example, the air conditioners A, which are HVAC devices.

(2-1) Installation Locations of Air Conditioners as HVAC Devices

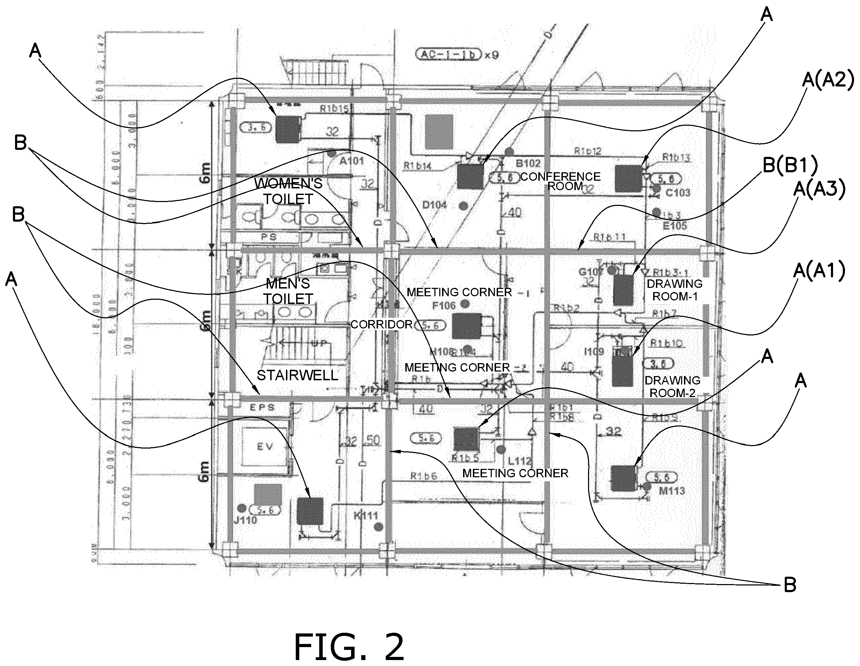

As illustrated in Fig. 1, the air conditioners A are air conditioning indoor units installed in an internal space of a building 81. The plurality of air conditioners A are arranged in a space above the ceiling of each floor (room) of the building 81. Fig. 1 illustrates three air conditioners A1, A2, and A3 installed in a space S above the ceiling of the first floor of the building 81. These air conditioners A1, A2, and A3 are the air conditioners A1, A2, and A3 illustrated in Fig. 2, which is a plan view including the space S above the ceiling of the first floor. In the space of the space S above the ceiling of the first floor, multiple beams B extend horizontally. As illustrated in Fig. 1 and Fig. 2, a beam B1 is present between the air conditioner A2 and the air conditioner A3.

(2-2) BLE Module

Each of the air conditioners A has the BLE module M built therein. The BLE module M has an RSSI and is capable of transmitting a radio wave and also measuring the strength of a received radio wave (received signal strength).
As illustrated in Fig. 1, the air conditioner A1 has a BLE module M1 built therein, the air conditioner A2 has a BLE module M2 built therein, and the air conditioner A3 has a BLE module M3 built therein.

(2-3) Computer as Machine Learning Apparatus

A computer 10 functioning as a machine learning apparatus is constituted by one or a plurality of computers and is connected to HVAC devices such as the air conditioners A in each building 81 via a communication network 80 such as the Internet. The computer 10 executes a cloud computing service constructed by a service provider of the HVAC management system to provide various services. The hardware configuration of the computer 10 does not need to be housed in a single housing or does not need to be included as a group of apparatuses.
As illustrated in Fig. 3, the computer 10 mainly includes an acquisition unit 20, the learning unit 30, an output unit 40, an input unit 50, and an update unit 60. The computer 10 includes a control arithmetic unit and a storage device. The control arithmetic unit can be implemented using a processor such as a CPU or a GPU. The control arithmetic unit reads a program stored in the storage device and performs predetermined image processing and arithmetic processing in accordance with the program. Further, the control arithmetic unit can write an arithmetic result to the storage device or read information stored in the storage device in accordance with the program. The acquisition unit 20, the learning unit 30, the output unit 40, the input unit 50, and the update unit 60 illustrated in Fig. 3 are various functional blocks implemented by the control arithmetic unit. These functional blocks appear in response to the control arithmetic unit executing a model creation program.

(2-3-1) Acquisition Unit

The acquisition unit 20 acquires, as information for obtaining state variables, air conditioner arrangement information (first information) 21 and ceiling-cavity-space beam arrangement information (first information) 22 from an external design drawing database 70. The design drawing database 70 stores design drawings and the like of the respective floors of the building 81. The air conditioner arrangement information 21 is information related to a location where the air conditioners A are arranged, as illustrated in Fig. 1 or Fig. 2. The air conditioner arrangement information 21 includes information such as data of the X coordinate and the Y coordinate of each of the air conditioners A in the plan view, and a distance between the air conditioners A. The beam arrangement information 22 includes data of the X coordinates and the Y coordinates of both ends of each of the beams B, information indicating between which two air conditioners A each of the beams B is located, and so on.
The air conditioner arrangement information 21 and the beam arrangement information 22 are, in other words, information related to something between a certain BLE module M and another BLE module M. The information on a distance between the air conditioners A is information on the distance between the BLE modules M built in these two air conditioners A. It is also possible to calculate information on the numbers of beams B and air conditioners A located between a certain BLE module M and another BLE module M from data of the X coordinate and the Y coordinate of each of the air conditioners A in the plan view and data of the X coordinates and the Y coordinates of both ends of each of the beams B.
Here, the acquisition unit 20 acquires, as state variables, the distance x between any two BLE modules M and the numbers x' of beams B and air conditioners A on the line segment connecting the two BLE modules M from a layout map of the air conditioners A and the beams B, which is extracted from the design drawing.
For example, one beam B1 and one air conditioner A3 are present between the BLE module M1 and another BLE module M2 illustrated in Fig. 1 and Fig. 2. One beam B1 and no air conditioner A are present between the BLE module M2 and another BLE module M3. Neither beam B1 nor air conditioner A is present between the BLE module M1 and another BLE module M3.

(2-3-2) Learning Unit

The learning unit 30 learns state variables and a radio wave propagation state between a BLE module M and another BLE module M in association with each other. The learning unit 30 learns the state variables and the radio wave propagation state in association with each other on the basis of a learning data set. The learning data set includes a measurement result 55 of the radio wave propagation state, which is a result of measuring the radio wave propagation state, and the state variables at the time of measurement of the radio wave propagation state.

As illustrated in Fig. 3, the measurement result 55 of the radio wave propagation state is information collected by the input unit 50 described below from the BLE module M of each of the air conditioners A installed in the building 81. The state variables at the time of measurement of the radio wave propagation state are specifically values obtained from information on the air conditioners A and the beams B installed in the building 81. Here, from a layout map of the air conditioners A and the beams B, which is extracted from the design drawing, the distance between any two BLE modules M and the numbers of beams B and air conditioners A on the line segment connecting the two BLE modules M are used as state variables at the time of measurement of the radio wave propagation state.

More specifically, the learning unit 30 learns the state variables and the radio wave propagation state in association with each other by adjusting a coefficient of the linear model 35 in Equation 12 as follows:

$$\hat{y}(w, x, x') = \sum_{i=1}^{p} \sum_{j=1}^{p} w_{ij} \, x^i x'^j$$

Equation 12

where

$\hat{y}(w, x, x')$ denotes an estimation result of the radio wave propagation state,
w denotes a coefficient,
x denotes a distance between a BLE module and another BLE module, and
x' denotes the numbers of beams and air conditioners located between the BLE module and the other BLE module.

(2-3-3) Output Unit

The output unit 40 outputs an estimation result 45 of the radio wave propagation state, which is obtained by the linear model 35 of the learning unit 30.

(2-3-4) Input Unit

The input unit 50 collects the measurement result 55 of the radio wave propagation state from the BLE module M of each of the air conditioners A installed in the building 81 via the communication network 80. Alternatively, the input unit 50 can collect the measurement result 55 of the radio wave propagation state from a user terminal 90 via the communication network 80.

(2-3-5) Update Unit

The update unit 60 determines the difference between the estimation result 45 of the radio wave propagation state output from the output unit 40 and the measurement result 55 of the radio wave propagation state input to the input unit 50. Then, the update unit 60 evaluates the difference to update the learning state of the learning unit 30.

Specifically, the update unit 60 updates the learning state of the learning unit 30 by updating the coefficient w in Equation 12 above so as to decrease an evaluation function 12 given as follows:

$$\|\hat{y}(w, x, x') - y\|^2 + \alpha \|w\|^2$$

where

ŷ(w, x, x') denotes the estimation result 45 of the radio wave propagation state,
y denotes the measurement result 55 of the radio wave propagation state, and
α denotes a regularization parameter.

(3) Features of Computer (Machine Learning Apparatus) of HVAC Management System

(3-1)

In general, if the distance between a transmitter and a receiver is the main cause of propagation path loss, a radio wave propagation in free space can be described by the Friis transmission equation. However, the space above the ceiling of a building typically has a height of 0.5 m or 1.5 m and is a very limited space. In addition, beams and HVAC devices are present in the space above the ceiling to maintain the strength of the building. In such a complex space, an obstacle on the radio wave propagation path, as well as the distance, may also greatly affect the propagation path loss due to reflection or refraction. It is therefore necessary to also consider an obstacle as a variable of the model. In particular, two types of obstacles made of metal and having a relatively large volume, beams and HVAC devices, are to be considered as variables of the linear model.

Accordingly, the computer 10 serving as a machine learning apparatus according to this embodiment focuses on the distance between a BLE module M and another BLE module M and the numbers of beams B and air conditioners A located between the BLE module M and the other BLE module M.

In the computer 10 of the HVAC management system according to this embodiment, the acquisition unit 20 acquires the air conditioner arrangement information (first information) 21 related to something between a BLE module M and another BLE module M and the ceiling-cavity-space beam arrangement information (first information) 22. Thus, the computer 10 can obtain state variables necessary for the learning unit 30 from such information. Since the learning unit 30 learns the state variables and the radio wave propagation state in association with each other, the computer 10 can obtain the radio wave propagation state between the BLE module M and the other BLE module M.

In addition, since the distance (x) between the BLE module M and the other BLE module M is adopted as a state variable, an accurate radio wave propagation state can be obtained.

In the computer 10, therefore, the learning unit 30 can obtain a relatively accurate radio wave propagation state in the narrow space S above the ceiling where it is difficult for an existing radio wave propagation simulation device to obtain an accurate result.

(3-2)

In the computer 10 serving as a machine learning apparatus according to this embodiment, the numbers (x') of beams B and air conditioners A located between the BLE module M and the other BLE module M are further adopted as state variables. In the computer 10, therefore, a more accurate radio wave propagation state can be obtained.

(3-3)

In the computer 10 serving as a machine learning apparatus according to this embodiment, each of the BLE modules M measures a radio wave propagation state in the building 81, and the learning unit 30 performs learning using a learning data set including the state variables at that time and the measurement result 55 of the radio wave propagation state. Specifically, the update unit 60 updates the learning state of the learning unit 30 by evaluating the difference between the estimation result 45 of the radio wave propagation state and the measurement result 55 of the radio wave propagation state. As a result, the coefficient w of the linear model 35 is set to an appropriate numerical value suitable for the arrangement of the beams B or the air conditioners A in the space above the ceiling of the building 81.

(4) Example Comparison between Model with One Variable and Model with Three Variables

EXAMPLES

The computer (machine learning apparatus) 10 described above focuses on two types of obstacles made of metal and having a relatively large volume, beams and air conditioners. First, the distance between any two BLE modules (distance) and the numbers of beams and air conditioners (#beam and #machine) on the line segment connecting the two BLE modules were acquired from a layout map extracted from the design drawing. Then, a predictive variable set including three variables (distance, #beam, and #machine) was created.

To evaluate the influence of #beam and #machine, the learning unit used both one variable (1-feature; distance), and three variables (3-feature; distance, #beam, #machine) to construct a linear model, and compared them to determine the difference between them.

For the one-variable model, OLS regression (Ordinary Linear Regression; normal least squares method) with polynomials was selected. The linear regression approximates the linear model using coefficients for minimizing the residual sum of squares between the observed responses in the data set and the responses predicted by linear approximation. Mathematically, the model can be expressed as follows:

$$\hat{y}(w, x) = w_0 + w_1 x_1 + \cdots + w_p x_p$$

where

x denotes a variable,
$\hat{y}$ denotes an estimation result of the radio wave propagation state, and
w denotes a coefficient.

The residual sum of squares (sometimes referred to also as a loss function) is expressed by the following expression:

$$\min_{w} \|Xw - y\|_2^{\ 2}$$

where

y denotes an RSSI attribute, and
X denotes a distance polynomial represented by:

$$d, d^2, ..., d^n$$

On the other hand, for the model with three variables (distance, #beam, #machine⟩ , ridge regression using a polynomial was selected. Ridge regression is also one type of generalized linear regression. Compared to OLS regression, ridge regression has a loss function with an additional penalty term.

$$\min_{w} \|Xw - y\|_2^{\ 2} + \alpha \|w\|_2^{\ 2}$$

As the value of $\alpha$ increases, the penalty also increases. Thus, the magnitude of the coefficient decreases.
In the first attempt to train the model, $\alpha = 10$ was applied to a model with each of the three (distance, #beam, #machine) variables.
For both OLS regression and ridge regression, the degree of the polynomial was changed from 1 to 4, and scaling was applied to each variable before regression. With the use of the functions of the machine learning library, the variables are first converted to a normal distribution, and then the maximum absolute value of each variable is scaled to 1.0.
The accuracy of linear model prediction is mainly evaluated by RMSE (Root Mean Square Error) and $R^2$ (coefficient of determination). Here, RMSE was adopted. RMSE is computed using the absolute difference between the estimated RSSI and the measured RSSI.
Here, RMSE computation was performed by the following two methods.

1) Both model training and testing (RMSE computation) were performed on the entire data set (100% data set).
2) K-fold cross-validation (K = 10) sets were randomly split into ten sets, in which a model was trained on nine sets and the trained model was tested on the remaining one set. Test set was repeated to test the model, and RMSE was computed 10 times. Then, the average of the ten RMSEs was used as an evaluation index.

In the experiment, data sampling was performed in a typical steel-framed building (office building) in which all the beams were made of metal.
The height of the space above the ceiling (from the bottom of the gypsum board to the top slab) is 0.85 m, the maximum height of the beams is 0.7 m, and the average height of the air conditioners is 0.3 m.
Each floor has an 18 m × 18 m flat ceiling. In the first floor and the second floor, 26 BLE modules are arranged. The distance between two BLE modules is 1.3 m to 20 m.
The data sampling process was performed for one week, during which the BLE modules exchanged communication packets and packet records were collected. The packet records include a time stamp, a transmitter ID, a receiver ID, transmission power (always set to 8 dBm for each BLE module), and an RSSI. Radio interference due to Wi-Fi in a building is serious problem depending on working hours. In consideration of this fact, RSSIs at night (22:00 to 7:00) and on weekends for model training were chosen. The RSSIs were further resampled at a time interval of 5 minutes for each pair of BLE modules, and the average value of RSSIs over the respective time intervals was used as the 100% data set described above.

Model evaluation results are shown in Table 1.

(Table 1)

| RMSE OF MODELS | | | | |
|---|---|---|---|---|
| Feature | Model Type | Degree | K-fold CV RMSE | 100% data set RMSE |
| distance | OSL | 1 | 5.304 | 5.253 |
| | | 2 | 5.220 | 5.154 |
| | | 3 | 5.226 | 5.154 |
| | | 4 | 5.195 | 5.117 |
| distance, #beam, #machine | Ridge: $\alpha=10$ | 1 | 5.059 | 5.004 |
| | | 2 | *4.953* | 4.830 |
| | | 3 | 4.900 | 4.731 |
| | | 4 | 4.832 | 4.623 |

Here, two types of RMSEs were computed. The RMSE for K-fold cross-validation showed larger values than that for the 100% data set. Both RMSEs showed the same tendency.

In many models having the same function, a model with a higher degree has a lower RMSE. Such a model additionally has the numbers of beams and air conditioners, as well as the distance, as variables, thereby improving the accuracy of the radio wave propagation model in the space above the ceiling.

Next, a comparison between the RSSIs indicated by the models and the RSSIs of the actual BLE modules is shown in Table 2. Among the eight models, the fourth-degree model with the three variables showed the best estimation accuracy. In Table 2, a difference is shown for all the pairs of BLE modules (not illustrated) including the BLE module indicated by "102A".

(Table 2)

| ESTIMATION RESULT FOR BLE 102 PAIRS | | | | | | |
|---|---|---|---|---|---|---|
| BLE Pair | distance | #beam | #machine | Estimated RSSI | Measured RSSI | Absolute Difference |
| 101, 102 | 6.30 | 1 | 0 | -61.58 | -71.33 | 9.76 |
| 102, 103 | 5.85 | 1 | 1 | -57.20 | -55.81 | 1.39 |
| 102, 104 | 2.72 | 0 | 0 | -49.03 | -54.91 | 5.88 |
| 102, 105 | 6.26 | 1 | 0 | -61.52 | -60.76 | 0.76 |
| 102, 106 | 6.16 | 1 | 0 | -61.33 | -59.91 | 1.42 |
| 102, 107 | 6.23 | 2 | 0 | -64.14 | -60.95 | 3.19 |
| 102, 108 | 8.04 | 1 | 1 | -61.58 | -58.54 | 3.04 |
| 102, 109 | 9.00 | 2 | 0 | -67.26 | -63.38 | 3.88 |
| 102, 110 | 17.06 | 3 | 2 | -80.67 | -80.73 | 0.06 |
| 102, 111 | 15.89 | 3 | 0 | -76.78 | -76.89 | 0.11 |
| 102, 112 | 12.01 | 2 | 0 | -71.82 | -73.39 | 1.57 |
| 102, 113 | 14.51 | 3 | 0 | -75.14 | -73.57 | 1.57 |

It is useful to use the RSSIs of the BLE modules described above to improve the process for setting the network addresses of the HVAC devices. It has been found through experiment that the RMSE for RSSI prediction has the following tendency.

1) Taking into consideration information related to obstacles, such as the number of beams and the number of HVAC devices such as air conditioners, reduces the RMSE.

2) As the degree of the polynomial increases, the RMSE decreases.

(5) Modifications

(5-1)
In the computer (machine learning apparatus) 10 described above, as a state variable for obstacles (the beams B and the air conditioners A) on the line segment connecting two BLE modules M, the number of obstacles is adopted. However, alternatively or additionally, the sizes of the obstacles may be used as a state variable.
(5-2)
In the computer (machine learning apparatus) 10 described above, as a state variable for obstacles (the beams B and the air conditioners A) on the line segment connecting two BLE modules M, the number of obstacles is adopted. However, alternatively or additionally, the positions of the obstacles may be used as a state variable.
(5-3)
In the computer (machine learning apparatus) 10 described above, as a state variable for obstacles (the beams B and the air conditioners A) on the line segment connecting two BLE modules M, the number of obstacles is adopted. However, alternatively or additionally, the orientations of the obstacles may be used as a state variable.
(5-4)
In the computer (machine learning apparatus) 10 described above, the learning unit 30 learns the state variables and the radio wave propagation state in association with each other by adjusting the coefficient of the linear model 35 in Equation 12 above. Alternatively, the learning unit 30 may learn the state variables and the radio wave propagation state in association with each other by adjusting a coefficient of a linear model in Equation 11 as follows:

$$\hat{y}(w, x) = \sum_{i=1}^{p} w_i\, x^i$$

Equation 11

where

$\hat{y}(w, x)$ denotes an estimation result of the radio wave propagation state,
w denotes a coefficient, and
x denotes a distance between a BLE module and another BLE module.

The update unit 60 may update the learning state of the learning unit 30 by updating the coefficient w in Equation 11 above so as to decrease, instead of the evaluation function 12 described above, an evaluation function 11 given as follows:

$$\|\hat{y}(w, x) - y\|^2$$

where

$\hat{y}(w, x)$ denotes the estimation result 45 of the radio wave propagation state, and
y denotes the measurement result 55 of the radio wave propagation state.

As described above, even when the learning state of the learning unit 30 is updated by updating the coefficient w of the linear model in Equation 11, it becomes possible to obtain an accurate radio wave propagation state.
(5-5)
In the HVAC management system described above, the air conditioners A, which are HVAC devices, are equipped with the BLE modules M. However, the air conditioners A may be equipped with other radio devices instead of BLE modules. For example, ZigBee modules may be adopted.

(6) Comparison between Estimated Value of Radio Wave Strength using Machine Learning Apparatus and Estimated Value of Radio Wave Strength using Existing Simulation

(6-1)
As described above, it is useful to estimate the radio wave propagation state between the BLE modules M by using the computer 10 serving as a machine learning apparatus to reduce the work (address setting work) for mapping the network addresses of the HVAC devices or the like to the physical locations of the HVAC devices or the like. Feedback control and, furthermore, energy saving in buildings and the development of intelligent control technology can be expected by sensing of the installation position of each air conditioner and automation of address setting.
Accordingly, each air conditioner is equipped with a BLE module, and the machine learning apparatus described above uses the reception strength of a radio wave output from the BLE module. The reception strength of a radio wave (radio wave strength) is one of the indices indicating the radio wave propagation state.
The radio wave strength between two points tends to decrease as the distance increases due to attenuation of radio waves caused by the distance. However, any obstruction of the propagation of radio waves between the two points increases the attenuation of the radio wave strength. In the related art, a simulation based on a physical model has been used to estimate the radio wave propagation strength, and such a simulation requires many input conditions (content of inputs) and is complicated. In existing address setting using a physical model, narrowing down the input conditions to a degree that can be utilized in the steady work causes a problem in that the accuracy is greatly degraded.
To address this, in the machine learning apparatus described above, a radio wave propagation model for predicting a radio wave strength measured on the basis of the distance between two BLE modules and an obstacle that obstructs radio wave propagation between the two BLE modules is constructed using machine learning.
The following presents results of comparison with an existing physical model by simulation to verify the validity of the model using machine learning.

(6-2) Comparison and Evaluation

First, in prediction using machine learning, the radio wave strength of BLE modules is used as an explained variable. Further, the distance between the BLE modules and the numbers of air conditioners and beams are used as explanatory variables (state variables). After a radio wave propagation model was learned using a measured value of the radio wave strength of a BLE module mounted in the ceiling cavity of a certain building, the radio wave strength was estimated using the learning model. In prediction accuracy evaluation using machine learning, accuracy evaluation was performed using the radio wave strength between 15 BLE modules installed in the ceiling cavity of the building.
In simulation prediction, a 3D model (model including air conditioners and beams) for an actual environment of the ceiling cavity of a certain building was created, reference values were input to material parameters, and a radio wave propagation simulation was performed to estimate the radio wave strength. Software for the simulation was implemented using a combination of a commercially available discrete-event simulator with an extension module for performing high-definition radio wave propagation. The simulation using this software enables execution of a simulation in a fine radio wave propagation environment in which the influences of reflection, shielding, and diffraction of radio waves by a building or the like are taken into account. In prediction accuracy evaluation by simulation, a radio wave strength between five BLE modules included in a building portion for which the 3D model was constructed was set as an object to be evaluated.
Simulation prediction requires, in addition to the input of material parameters, the creation of a BIM model (3D digital model of the building) in the absence of the BIM model, and thus requires more complex work than that using a learning model.
The results of the accuracy evaluation performed in accordance with the procedure described above are shown in Table 3 below.

(Table 3)

| | Number of BLE modules | Average value (dBm) of measured values of radio wave strength | Standard deviation (dBm) of measured values of radio wave strength | Square error between estimated value and measured value: RMSE (dBm) | Maximum error between estimated value and measured value: Max Error (dBm) |
|---|---|---|---|---|---|
| Simulation | 5 | -71.91 | 3.01 | 11.14 | 17.29 |

## EP 3 955 587 B1

(continued)

|  | Number of BLE modules | Average value (dBm) of measured values of radio wave strength | Standard deviation (dBm) of measured values of radio wave strength | Square error between estimated value and measured value: RMSE (dBm) | Maximum error between estimated value and measured value: Max Error (dBm) |
|---|---|---|---|---|---|
| Machine learning | 13 | -66.97 | 9.17 | 3.82 | 9.82 |

It is indicated that for the simulation, the standard error of measured values of the radio wave strength is smaller, but the estimation error is larger.

The results described above indicate that the method using machine learning can predict the radio wave strength with better accuracy than the method using a simulation. Although learning is performed using fewer state variables than the input conditions in the simulation, the use of a learning model provides higher accuracy.

Matching of Installation Position of Each Air Conditioner and BLE Module

The radio wave strength as the radio wave propagation state obtained by the machine learning apparatus described above is used in a matching algorithm between a device installation position and a BLE module for specifying the position of the BLE module in the next step. In the matching between a device installation position and a BLE module, first, an undirected graph GE whose edges have values representing estimated received radio wave intensities obtained by the machine learning method described above and vertices representing position IDs of air conditioners is obtained. Then, the BLE modules built in the air conditioners in the building (on site), which is the target property, mutually perform transmission. The measured received radio wave intensities of the BLE modules are collected, and an undirected graph GM whose edges have values representing the measured reception strengths and vertices representing the IDs of a transmitter BLE module and a receiver BLE module is created. Note that there is always an error between an estimated value and a measured value of the radio wave strength. To address this, an error allowance (slack value) is set. Accordingly, it is determined that an edge of the undirected graph GM and an edge of the undirected graph GE between which the error is less than or equal to the allowance can be the same. Then, a matching algorithm of the undirected graph GM to the undirected graph GE is performed to determine (a plurality of) BLE modules as matching candidates for the installation position of each air conditioner.

If the matching described above is performed using an estimated radio wave strength value using a simulation, when BLE module candidates are determined for each installation position using the same algorithm and the same error allowance, the determined BLE module candidates may often include no correct answer. Conversely, in a case where a larger error allowance is used so that a correct answer can be included, the number of determined BLE module candidates increases, making it difficult to narrow down correct answers.

(8) While an embodiment of an HVAC management system including the computer 10 serving as a machine learning apparatus has been described above, it will be understood that forms and details can be changed in various ways without departing from the scope of the appended claims.

REFERENCE SIGNS LIST

10 computer (machine learning apparatus)
20 acquisition unit
21 air conditioner arrangement information (first information; object information)
22 ceiling-cavity-space beam arrangement information (first information; object information)
30 learning unit
35 linear model
40 output unit
45 estimation result of radio wave propagation state
55 measurement result of radio wave propagation state
60 update unit
A (A1, A2, A3) air conditioner (predetermined object)

B (B1) beam (predetermined object)
M (M1, M2, M3) BLE module (radio device)

**CITATION LIST**

**PATENT LITERATURE**

PTL 1: Japanese Unexamined Patent Application Publication No. 2016-208265

**Claims**

1. A machine learning apparatus (10), comprising:

   an acquisition unit (20) configured to acquire first information (21, 22) as information for obtaining one or more state variables,
   **characterized in that**:

      the first information is related to something between a radio device (M1) and another radio device (M2); and
      the machine learning apparatus further comprises
      a learning unit (30) configured to learn the one or more state variables and a radio wave propagation state in association with each other,
      the radio wave propagation state being at least one of

         amount of radio wave attenuation between the radio device and the other radio device,
         minimum transmission radio wave strength of the radio device that can be received by the other radio device,
         received radio wave strength of the other radio device relative to the transmission from the radio device at a predetermined transmission radio wave strength, and
         ratio of received radio signal strength in the other radio device to the transmitted radio signal strength of the radio device.

2. The machine learning apparatus according to Claim 1, wherein

   the first information includes information (21) on a distance between the radio device and the other radio device, and
   the distance between the radio device and the other radio device is at least one of the one or more state variables.

3. The machine learning apparatus according to Claim 1 or 2, wherein
   the first information includes object information (21, 22) related to one or more of predetermined objects located between the radio device and the other radio device.

4. The machine learning apparatus according to Claim 3, wherein
   the object information includes information on a number of the one or more predetermined objects.

5. The machine learning apparatus according to Claim 3 or 4, wherein
   the one or more of predetermined objects comprise an air conditioner (A) and/or a beam (B) arranged in a space above a ceiling.

6. The machine learning apparatus according to any of Claims 3 to 5, wherein
   the object information includes information related to the size of each of the one or more predetermined objects.

7. The machine learning apparatus according to any of Claims 3 to 6, wherein
   the object information includes information related to the position of each of the one or more predetermined objects.

8. The machine learning apparatus according to any of Claims 3 to 7, wherein
   the object information includes information related to the orientation of each of the one or more predetermined objects.

9. The machine learning apparatus according to Claim 1 or 2, wherein
the learning unit is configured to learn the one or more state variables and the radio wave propagation state in association with each other, based on a learning data set including a result (55) of measuring the radio wave propagation state and the one or more state variables at a time of measurement of the radio wave propagation state.

10. The machine learning apparatus according to any of Claims 3 to 8, wherein
the learning unit is configured to learn the one or more state variables and the radio wave propagation state in association with each other, based on a learning data set including a result (55) of measuring the radio wave propagation state and the one or more state variables obtained from the object information at a time of measurement of the radio wave propagation state.

11. The machine learning apparatus according to any of Claims 1, 2, and 9, wherein
the learning unit is configured to learn the one or more state variables and the radio wave propagation state in association with each other by adjusting a coefficient of a linear model (35) in Equation 1 as follows:

$$\hat{y}(w, x) = \sum_{i=1}^{p} w_i\, x^i$$

Equation 1

where

$\hat{y}(w, x)$ denotes an estimation result of the radio wave propagation state,
w denotes a coefficient, and
x denotes a distance between the radio device and the other radio device.

12. The machine learning apparatus according to any of Claims 3 to 8, and 10, wherein
the learning unit is configured to learn the one or more state variables and the radio wave propagation state in association with each other by adjusting a coefficient of a linear model (35) in Equation 2 as follows:

$$\hat{y}(w, x, x') = \sum_{i=1}^{p} \sum_{j=1}^{p} w_{ij}\, x^i x'^j$$

Equation 2

where

$\hat{y}(w, x, x')$ denotes an estimation result of the radio wave propagation state,
w denotes a coefficient,
x denotes a distance between the radio device and the other radio device, and
x' denotes the number of the one or more predetermined objects located between the radio device and the other radio device.

13. The machine learning apparatus according to any of Claims 1 to 12, further comprising:

an output unit (40) configured to output an estimation result of the radio wave propagation state; and
an update unit (60) configured to update a learning state of the learning unit,
wherein
the update unit is configured to update the learning state of the learning unit by evaluating a difference between the estimation result (45) of the radio wave propagation state and a result (55) of measuring the radio wave propagation state.

14. The machine learning apparatus according to Claim 11, further comprising:

an output unit (40) configured to output an estimation result of the radio wave propagation state; and
an update unit (60) configured to update a learning state of the learning unit,
wherein
the update unit is configured to update the learning state of the learning unit by updating the coefficient w in the Equation 1 so as to decrease an evaluation function 1 given as follows:

$$\|\hat{y}(w, x) - y\|^2$$

where

$\hat{y}(w, x)$ denotes the estimation result of the radio wave propagation state, and
y denotes a result of measuring the radio wave propagation state.

15. The machine learning apparatus according to Claim 12, further comprising:

an output unit (40) configured to output an estimation result of the radio wave propagation state; and
an update unit (60) configured to update a learning state of the learning unit,
wherein
the update unit is configured to update the learning state of the learning unit by updating the coefficient w in the Equation 2 so as to decrease an evaluation function 2 given as follows:

$$\|\hat{y}(w, x, x') - y\|^2 + \alpha\|w\|^2$$

where

$\hat{y}(w, x, x')$ denotes the estimation result of the radio wave propagation state,
y denotes a result of measuring the radio wave propagation state, and
$\alpha$ denotes a regularization parameter.


**Patentansprüche**

1. Maschinelle Lernvorrichtung (10), die aufweist:

eine Erfassungseinheit (20), die konfiguriert ist, erste Informationen (21, 22) als Informationen zum Erhalten von einer oder mehrerer Zustandsvariablen zu erfassen,
**dadurch gekennzeichnet, dass**:

die ersten Informationen sich auf etwas zwischen einer Funkvorrichtung (M1) und einer anderen Funkvorrichtung (M2) beziehen, und
die maschinelle Lernvorrichtung ferner aufweist
eine Lerneinheit (30), die konfiguriert ist, die eine oder die mehreren Zustandsvariablen und einen Funkwellenausbreitungszustand in Verbindung miteinander lernt,

wobei der Funkwellenausbreitungszustand mindestens eines ist von Betrag der Funkwellendämpfung zwischen der Funkvorrichtung und der anderen Funkvorrichtung,
minimale Sendefunkwellenstärke der Funkvorrichtung, die von der anderen Funkvorrichtung empfangen werden kann,
empfangene Funkwellenstärke der anderen Funkvorrichtung im Verhältnis zur Sendung der Funkvorrichtung bei einer vorbestimmten Sendefunkwellenstärke, und
Verhältnis der empfangenen Funksignalstärke im anderen Funkvorrichtung zur gesendeten Funksignalstärke der Funkvorrichtung.

2. Maschinelle Lernvorrichtung nach Anspruch 1, wobei

die ersten Informationen Informationen (21) über einen Abstand zwischen der Funkvorrichtung und der anderen Funkvorrichtung aufweisen, und

der Abstand zwischen der Funkvorrichtung und der anderen Funkvorrichtung mindestens eine der einen oder mehreren Zustandsvariablen ist.

3. Maschinelle Lernvorrichtung nach Anspruch 1 oder 2, wobei
die ersten Informationen Objektinformationen (21, 22) aufweisen, die sich auf ein oder mehrere vorbestimmte Objekte beziehen, die sich zwischen der Funkvorrichtung und der anderen Funkvorrichtung befinden.

4. Maschinelle Lernvorrichtung nach Anspruch 3, wobei
die Objektinformationen Informationen über eine Anzahl des einen oder der mehreren vorbestimmten Objekte enthalten.

5. Maschinelle Lernvorrichtung nach Anspruch 3 oder 4, wobei
das eine oder die mehreren vorbestimmten Objekte eine Klimaanlage (A) und/oder einen Balken (B) aufweisen, der in einem Raum über einer Decke angeordnet ist.

6. Maschinelle Lernvorrichtung nach einem der Ansprüche 3 bis 5, wobei
die Objektinformationen Informationen aufweisen, die sich auf die Größe jedes des einen oder der mehreren vorbestimmten Objekte beziehen.

7. Maschinelle Lernvorrichtung nach einem der Ansprüche 3 bis 6, wobei
die Objektinformationen Informationen aufweisen, die sich auf die Position jedes des einen oder der mehreren vorbestimmten Objekte beziehen.

8. Maschinelle Lernvorrichtung nach einem der Ansprüche 3 bis 7, wobei
die Objektinformationen Informationen aufweisen, die sich auf die Ausrichtung jedes des einen oder der mehreren vorbestimmten Objekte beziehen.

9. Maschinelle Lernvorrichtung nach Anspruch 1 oder 2, wobei
die Lerneinheit konfiguriert ist, die eine oder die mehreren Zustandsvariablen und den Funkwellenausbreitungszustand in Verbindung miteinander zu lernen, basierend auf einem Lerndatensatz, der ein Ergebnis (55) der Messung des Funkwellenausbreitungszustands und der einen oder mehreren Zustandsvariablen zu einem Zeitpunkt der Messung des Funkwellenausbreitungszustands umfasst.

10. Maschinelle Lernvorrichtung nach einem der Ansprüche 3 bis 8, wobei
die Lerneinheit konfiguriert ist, die eine oder die mehreren Zustandsvariablen und den Funkwellenausbreitungszustand in Verbindung miteinander zu lernen, basierend auf einem Lerndatensatz, der ein Ergebnis (55) der Messung des Funkwellenausbreitungszustands und die eine oder die mehreren Zustandsvariablen umfasst, die aus den Objektinformationen zu einem Zeitpunkt der Messung des Funkwellenausbreitungszustands erhalten werden.

11. Maschinelle Lernvorrichtung nach einem der Ansprüche 1, 2 und 9, wobei die Lerneinheit konfiguriert ist, die eine oder mehreren Zustandsvariablen und den Funkwellenausbreitungszustand in Verbindung miteinander zu lernen, indem sie einen Koeffizienten eines linearen Modells (35) in Gleichung 1 wie folgt anpasst:

$$\hat{y}(w, x) = \sum_{i=1}^{p} w_i x^i$$

## Gleichung 1

wobei $\hat{y}(w, x)$ ein Schätzergebnis des Funkwellenausbreitungszustands bezeichnet,
w einen Koeffizienten bezeichnet und
x eine Entfernung zwischen der Funkvorrichtung und der anderen Funkvorrichtung bezeichnet.

12. Maschinelle Lernvorrichtung nach einem der Ansprüche 3 bis 8 und 10, wobei die Lerneinheit konfiguriert ist, die eine oder mehrere Zustandsvariablen und den Funkwellenausbreitungszustand in Verbindung miteinander zu lernen, indem sie einen Koeffizienten eines linearen Modells (35) in Gleichung 2 wie folgt anpasst:

$$\hat{y}(w, x, x') = \sum_{i=1}^{p} \sum_{j=1}^{p} w_{ij}\, x^{i} x'^{j}$$

Gleichung 2

wobei $\hat{y}(w, x, x')$ ein Schätzergebnis des Funkwellenausbreitungszustands bezeichnet,

w einen Koeffizienten bezeichnet,

x einen Abstand zwischen der Funkvorrichtung und der anderen Funkvorrichtung bezeichnet, und

x' die Anzahl des einen oder der mehreren vorbestimmten Objekte bezeichnet, die sich zwischen der Funkvorrichtung und der anderen Funkvorrichtung befinden.

13. Maschinelle Lernvorrichtung nach einem der Ansprüche 1 bis 12, die ferner aufweist:

eine Ausgabeeinheit (40), die konfiguriert ist, ein Schätzergebnis des Funkwellenausbreitungszustands auszugeben; und
eine Aktualisierungseinheit (60), die konfiguriert ist, einen Lernzustand der Lerneinheit zu aktualisieren, wobei
die Aktualisierungseinheit konfiguriert ist, den Lernzustand der Lerneinheit durch Auswerten einer Differenz zwischen dem Schätzergebnis (45) des Funkwellenausbreitungszustands und einem Ergebnis (55) der Messung des Funkwellenausbreitungszustands zu aktualisieren.

14. Maschinelle Lernvorrichtung nach Anspruch 11, die ferner aufweist:

eine Ausgabeeinheit (40), die konfiguriert ist, ein Schätzergebnis des Funkwellenausbreitungszustands auszugeben; und
eine Aktualisierungseinheit (60), die konfiguriert ist, um einen Lernzustand der Lerneinheit zu aktualisieren, wobei
die Aktualisierungseinheit konfiguriert ist, den Lernzustand der Lerneinheit durch Aktualisieren des Koeffizienten w in der Gleichung 1 zu aktualisieren, um eine Bewertungsfunktion 1, die wie folgt gegeben ist, zu verringern:

$$\|\hat{y}(w, x) - y\|^{2}$$

wobei

$\hat{y}(w, x)$ das Schätzergebnis des Funkwellenausbreitungszustands bezeichnet und
y ein Ergebnis der Messung des Funkwellenausbreitungszustands bezeichnet.

15. Maschinelle Lernvorrichtung nach Anspruch 12, die ferner aufweist:

eine Ausgabeeinheit (40), die konfiguriert ist, ein Schätzergebnis des Funkwellenausbreitungszustands auszugeben; und
eine Aktualisierungseinheit (60), die konfiguriert ist, einen Lernzustand der Lerneinheit zu aktualisieren, wobei
die Aktualisierungseinheit konfiguriert ist, den Lernzustand der Lerneinheit durch Aktualisieren des Koeffizienten w in der Gleichung 2 zu aktualisieren, um eine Bewertungsfunktion 2, die wie folgt gegeben ist, zu verringern:

$$\|\hat{y}(w, x, x') - y\|^{2} + \alpha\|w\|^{2}$$

wobei

$\hat{y}(w, x, x')$ das Schätzergebnis des Funkwellenausbreitungszustands bezeichnet,
y ein Ergebnis der Messung des Funkwellenausbreitungszustands bezeichnet, und
$\alpha$ einen Regularisierungsparameter bezeichnet.

**Revendications**

1. Dispositif d'apprentissage automatique (10), comprenant :

   une unité d'acquisition (20) configurée pour acquérir des premières informations (21, 22) en tant qu'informations permettant d'obtenir une ou plusieurs variables d'état,
   **caractérisé en ce que** :

   les premières informations sont relatives à quelque chose entre un premier dispositif radio (M1) et un autre dispositif radio (M2) ; et **en ce que**
   ledit dispositif d'apprentissage automatique comprend en outre
   une unité d'apprentissage (30) configurée pour apprendre la ou les variables d'état et un état de propagation des ondes radio en association les unes avec les autres,

   l'état de propagation des ondes radio étant
   un degré d'atténuation des ondes radio entre le premier dispositif radio et l'autre dispositif radio,
   et/ou une intensité minimale des ondes radio d'émission du premier dispositif radio pouvant être reçues par l'autre dispositif radio,
   et/ou une intensité des ondes radio reçues par l'autre dispositif radio par rapport à l'émission du premier dispositif radio à une intensité prédéterminée des ondes radio d'émission,
   et/ou un rapport entre l'intensité du signal radio reçu dans l'autre dispositif radio et l'intensité du signal radio émis par le premier dispositif radio.

2. Dispositif d'apprentissage automatique selon la revendication 1, où

   les premières informations comprennent des informations (21) sur une distance entre le premier dispositif radio et l'autre dispositif radio, et
   la distance entre le premier dispositif radio et l'autre dispositif radio est au moins l'une des variables d'état.

3. Dispositif d'apprentissage automatique selon la revendication 1 ou la revendication 2, où
   les premières informations comprennent des informations d'objet (21, 22) relatives à un ou plusieurs d'objets prédéterminés situés entre le premier dispositif radio et l'autre dispositif radio.

4. Dispositif d'apprentissage automatique selon la revendication 3, où
   les informations d'objet comprennent des informations sur le nombre du ou des objets prédéterminés.

5. Dispositif d'apprentissage automatique selon la revendication 3 ou la revendication 4, où
   le ou les objets prédéterminés comprennent un climatiseur (A) et/ou une poutrelle (B) disposés dans un espace au-dessus d'un plafond.

6. Dispositif d'apprentissage automatique selon l'une des revendications 3 à 5, où les informations d'objet comprennent des informations relatives à la dimension de l'objet, ou de chacun des objets prédéterminés.

7. Dispositif d'apprentissage automatique selon l'une des revendications 3 à 6, où les informations d'objet comprennent des informations relatives à la position de de l'objet, ou de chacun des objets prédéterminés.

8. Dispositif d'apprentissage automatique selon l'une des revendications 3 à 7, où les informations d'objet comprennent des informations relatives à l'orientation de l'objet, ou de chacun des objets prédéterminés.

9. Dispositif d'apprentissage automatique selon la revendication 1 ou la revendication 2, où
   l'unité d'apprentissage est configurée pour apprendre la ou les variables d'état et l'état de propagation des ondes radio en association les unes avec les autres, sur la base d'un ensemble de données d'apprentissage comprenant un résultat (55) de mesure de l'état de propagation des ondes radio et la ou les variables d'état à un moment de mesure de l'état de propagation des ondes radio.

10. Dispositif d'apprentissage automatique selon l'une des revendications 3 à 8, où l'unité d'apprentissage est configurée pour apprendre la ou les variables d'état et l'état de propagation des ondes radio en association les unes avec les autres, sur la base d'un ensemble de données d'apprentissage comprenant un résultat (55) de mesure de l'état de propagation des ondes radio et la ou les variables d'état obtenues à partir des informations d'objet à un moment de mesure de l'état de propagation des ondes radio.

11. Dispositif d'apprentissage automatique selon l'une des revendications 1, 2 et 9, où l'unité d'apprentissage est configurée pour apprendre la ou les variables d'état et l'état de propagation des ondes radio en association les unes avec les autres en ajustant comme suit un coefficient d'un modèle linéaire (35) dans l'équation 1 :

$$\hat{y}(w, x) = \sum_{i=1}^{p} w_i x^i$$

Équation 1

où $\hat{y}(w, x)$ représente un résultat d'estimation de l'état de propagation des ondes radio,
w représente un coefficient, et
x représente la distance entre le premier dispositif radio et l'autre dispositif radio.

12. Dispositif d'apprentissage automatique selon l'une des revendications 3 à 8, et 10, où l'unité d'apprentissage est configurée pour apprendre la ou les variables d'état et l'état de propagation des ondes radio en association les unes avec les autres en ajustant comme suit un coefficient d'un modèle linéaire (35) dans l'équation 2 :

$$\hat{y}(w, x, x') = \sum_{i=1}^{p} \sum_{j=1}^{p} w_{ij} x^i x'^j$$

Équation 2

Où $\hat{y}(w, x, x')$ représente un résultat d'estimation de l'état de propagation des ondes radio,
w représente un coefficient,
x représente la distance entre le premier dispositif radio et l'autre dispositif radio, et x' représente le nombre du ou des objets prédéterminés situés entre le premier dispositif radio et l'autre dispositif radio.

13. Dispositif d'apprentissage automatique selon l'une des revendications 1 à 12, comprenant en outre :

une unité de sortie (40) configurée pour émettre un résultat d'estimation de l'état de propagation des ondes radio ; et.
une unité de mise à jour (60) configurée pour mettre à jour un état d'apprentissage de l'unité d'apprentissage, où
l'unité de mise à jour est configurée pour mettre à jour l'état d'apprentissage de l'unité d'apprentissage en évaluant une différence entre le résultat d'estimation (45) de l'état de propagation des ondes radio et un résultat (55) de mesure de l'état de propagation des ondes radio.

14. Dispositif d'apprentissage automatique selon la revendication 11, comprenant en outre :

une unité de sortie (40) configurée pour produire un résultat d'estimation de l'état de propagation des ondes radio ; et
une unité de mise à jour (60) configurée pour mettre à jour un état d'apprentissage de l'unité d'apprentissage, où
l'unité de mise à jour est configurée pour mettre à jour l'état d'apprentissage de l'unité d'apprentissage en mettant à jour le coefficient w dans l'équation 1 de manière à diminuer une fonction d'évaluation 1 donnée comme suit :

$$\|\hat{y}(w, x) - y\|^2$$

où

$\hat{y}(w, x)$ représente le résultat d'estimation de l'état de propagation des ondes radio, et
y représente le résultat de mesure de l'état de propagation des ondes radio.

15. Dispositif d'apprentissage automatique selon la revendication 12, comprenant en outre :

une unité de sortie (40) configurée pour produire un résultat d'estimation de l'état de propagation des ondes radio ; et
une unité de mise à jour (60) configurée pour mettre à jour un état d'apprentissage de l'unité d'apprentissage, où
l'unité de mise à jour est configurée pour mettre à jour l'état d'apprentissage de l'unité d'apprentissage en mettant à jour le coefficient w dans l'équation 2 de manière à diminuer une fonction d'évaluation 2 donnée comme suit :

$$\|\hat{y}(w, x, x') - y\|^2 + \alpha \|w\|^2$$

où

$\hat{y}(w, x, x')$ représente le résultat d'estimation de l'état de propagation des ondes radio,
y représente le résultat de mesure de l'état de propagation des ondes radio, et
$\alpha$ représente un paramètre de régularisation.

FIG. 1

ROOM IN SECOND FLOOR

SPACE (S) ABOVE CEILING OF FIRST FLOOR

A(A1)   A(A3)   B(B1)   A(A2)

M(M1)   M(M3)   M(M2)

C

ROOM IN FIRST FLOOR

81

FIG. 2

COMPUTER (MACHINE LEARNING APPARATUS) 10

ACQUISITION UNIT 20

AIR CONDITIONER ARRANGEMENT INFORMATION 21

CEILING-CAVITY-SPACE BEAM ARRANGEMENT INFORMATION 22

STATE VARIABLE

LEARNING UNIT 30

LINEAR MODEL 35

UPDATE UNIT 60

OUTPUT UNIT 40

ESTIMATION RESULT OF RADIO WAVE PROPAGATION STATE 45

INPUT UNIT 50

MEASUREMENT RESULT OF RADIO WAVE PROPAGATION STATE 55

DESIGN DRAWING 70

NETWORK 80

USER TERMINAL 90

BUILDING 81

BUILDING A

A

FIG. 3

24

**EP 3 955 587 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2017117841 A1
- CN 106707035 A
- JP 2016208265 A